# EUROPÄISCHE PATENTANMELDUNG

(11) **EP 2 712 514 A1**
(43) Veröffentlichungstag der Anmeldung: **02.04.2014**
(21) Anmeldenummer: 13181968.2
(22) Anmeldetag: 28.08.2013
(51) Int. Cl.: A45D 34/00, B65D 23/02, A61J 1/00, C23C 14/00

(54) **Reduktion von Parfümölzugaben durch SiOx-Beschichtung**

(30) Priorität: 28.09.2012 DE 102012217695
(71) Anmelder: Beiersdorf AG, 20253 Hamburg (DE)
(72) Erfinder: Sperber, Oliver, 22085 Hamburg (DE); Eckers, Lorenz, 21255 Tostedt (DE)

(57) **Zusammenfassung**

Die Erfindung bezieht sich auf Behältnisse und Applikatoren für kosmetische und dermatologische Produkte, deren Barriereeigenschaften durch Oberflächenbehandlung modifiziert wurden um Veränderungen des olfaktorischen Eindruckes auszuschließen. Die kosmetischen und/oder dermatologischen Zubereitungen enthalten mindestens ein Parfümöl.

## Beschreibung

Die Erfindung bezieht sich auf Behältnisse, Funktions- und Systemverpackungen sowie Applikatoren für kosmetische und dermatologische Produkte, deren Stabilität, Funktionalität oder optischer Eindruck durch Interaktion mit dem Produkt oder den darin enthaltenen Zubereitungsbestandteilen (Parfümölen) aufgrund von Migration derselben in und durch die verwendeten Packmaterialien (z. B. Kunststoff) beeinträchtigt werden und sich die Zubereitungen selbst geruchlich (olfaktorisch) negativ verändern.

Im pharmazeutischen Sektor, sowie in der kosmetischen Industrie, sind die Ansprüche an Packmittelmaterialien sehr hoch, insbesondere in Bezug auf Transparenz, chemischer und biologischer Reaktivität, Absorptionsvermögen, Permeabilität. Diese Anforderungen sind umso größer, wenn ein Packmittel zur Aufbewahrung von Flüssigkeiten verwendet wird und die Flüssigkeit eine Vielzahl von Komponenten, z. B. polaren Komponenten, unpolaren Komponenten, Ionen, Salzen, Ölen, Tensiden, oberflächenaktiven Substanzen, Konservierungsmitteln, Polymeren und makromolekularen Substanzen, enthalten.

Pharmazeutische und kosmetische Zubereitungen sind aus einer Vielzahl von Einzelkomponenten aufgebaute Kompositionen. Auch wenn im pharmazeutischen Sektor und der kosmetischen Industrie bereits synthetische Packmittel, insbesondere Kunststoffe, Verwendung finden, zeigen sich Probleme mit der Permeabilität, Reaktivität und Absorption, so dass vielfach zerbrechliches und schweres Glas als Behältermaterial eingesetzt werden muss.

Kosmetische und dermatologische Zubereitungen werden zunehmend komplizierter. Waren die Grundlagen für kosmetische und dermatologische Zubereitungen in der Vergangenheit einfache Emulsionssysteme, so werden heutzutage eine ganze Palette von kosmetischen und dermatologischen Wirk- und Hilfsstoffen in die Zubereitungen eingearbeitet. Auch die Emulsionsgrundlagen basieren auf zunehmend komplexeren Emulgatorsystemen, die einen entscheidenden Beitrag zur Produktperformance liefern.

Die früher gebräuchlichen Applikationsformen als Krem oder Lotion wurde in den letzten Jahrzehnten durch neue Applikationsformen wie zum Beispiel Pumpsprays und Roll-on erweitert. Die dazu eingesetzten Packmittel sind damit nicht mehr die klassische Glasflasche oder Blechdose, sondern in der Regel Kunststoff-Behältnisse und -Applikatoren.

Glas stellt für moderne kosmetische und dermatologische Zubereitungen immer noch ein ideales Behältermaterial dar, da es nur in sehr seltenen Fällen mit den Inhaltsstoffen wechselwirkt und keinerlei Diffusion von Inhaltsstoffen in das Glas erfolgt.

Durch die eingeschränkten Gestaltungsmöglichkeiten, die Bruchanfälligkeit und das hohe Gewicht von Glas ist der Einsatz jedoch rückläufig und es wird auf moderne Materialien wie Kunststoffe zurückgegriffen. Die aus Kostengründen für Massenprodukte verwendbaren Kunststoffe haben jedoch den Nachteil, dass relativ häufig Wechselwirkungen mit den Zubereitungen auftreten. Neben der Reaktion des Kunststoffes mit dem Inhalt, ist die Diffusion von Zubereitungsbestandteilen in und durch den Kunststoff das häufigste Problem.

Diffundieren Zubereitungsbestandteile, wie z. B. Parfümöle, durch die Behälterwandung hindurch oder in die Behälterwand hinein, so verringert sich der Anteil des Zubereitungsbestandteils in der Rezeptur. Hierdurch wird der gesamte olfaktorische Eindruck des Produktes negativ beeinflusst, denn nicht alle Bestandteile eines Parfüms diffundieren in gleicher Weise oder Menge in oder durch die Behälterwand. Dies kann dann zu Absatzschwierigkeiten des Produktes am Markt führen. Um dieses Problem zu lösen, werden in besonderen Fällen die Mengen des Parfümöls deutlich erhöht. Dies stellt keine befriedigende denn teure Lösung dar. Dadurch ist bei ,frischen' Produkten eine Überparfümierung für den Verbraucher deutlich spürbar, währen bei schon eine Weile im Gebrauch befindlichen Produkten eine verfälschte und zur geringe Parfümierung auffällt.

Die EP 1722962 schildert die Schwierigkeiten synthetischer Verpackungsmaterialien für kosmetische und pharmazeutische Produkte. Es werden darin insbesondere einzelne Nachteile der Verpackungsmaterialien aus Polyvinylchloride (PVC), Polyethylen (PE), Polypropylen (PP) oder Polybuten (PB) dargestellt, durch die verschiedene Öle migrieren können. Als Problemlösung wird der Einsatz von auf die Beschichtung der Packmittel mit resistenten Materialien, wie Acrylnitrile oder Polychlortrifluorethylen hingewiesen.

Die EP 1722962 offenbart jedoch als Lösung Folien zur Verpackung flüssiger Produkte oder dergleichen, wobei die Folie eine erste Polyolefinschicht, eine Verbindungsschicht, gebildet aus Copolymer eines Polyolefins und Glycidylmethacrylat, und eine Schicht aus Polychlortrifluorethylen (PCTFE) umfasst. Behältnisse aus diesen Folien sind jedoch labil und eignen sich daher nicht für Verpackungen denen über einen längeren Zeitraum Produkte entnommen werden sollen.

Die DE 102008034957 offenbart einen anderen Lösungsansatz zur Vermeidung der Ölmigration durch ein polyolefinisches Packmittel, indem Ölmigrationsinhibitoren der Emulsionszubereitung zugesetzt werden. Diese Inhibitoren vermindern bzw. verhindern die Migration verschiedener Öle in bzw. durch das polyolefinische Packmittel.

Wie die Ausführungen in der DE 102008034957 zu Polyolefin-Verpackungen zeigen, ist die Chemikalienbeständigkeit bei allen Polyolefinen gut, jedoch beispielsweise die Diffusion von Gasen sowie von Aromastoffen und ätherischen Substanzen durch PE relativ hoch.

Es zeigt sich weiterhin, dass es Probleme bei der Verpackung von lipidhaltigen kosmetischen Zubereitungen in Polyolefinverpackungen gibt.

So sind beispielsweise kosmetische Deodorantien oder Antitranspirantien in Form von Mikroemulsionen nicht mit polyolefinischen Packmitteln, insbesondere Polypropylen-Packmitteln, kompatibel. Das bedeutet, die in diesen beispielhaften Deo-/AT-Zubereitungen enthaltene Lipidkomponente Dicaprylylether diffundiert mit der Zeit durch das PP-Packmittel und bewirkt so eine Verölung der äußeren Packmitteloberfläche und das Ablösen von Etiketten.

Nachteilig ist, dass zur Lösung der Migrationsproblematik gemäß DE 102008034957 der Zubereitung bestimmte Migrationsinhibitoren zugesetzt werden müssen. Dies wiederum schränkt die Formulierungsfreiheit ein bzw. erfordert eine aufwendige Anpassung der Zubereitung an diese Migrationsinhibitoren.

Wünschenswert ist es daher Packmittel unterschiedlicher Materialien und Zubereitungen unterschiedlichen Inhalts zusammen zu führen ohne dass es zu den beschriebenen Quellungen oder Migrationsproblemen kommt.

Ziel und Aufgabe der Erfindung ist es preisgünstige Behältnissen, Funktions- und Systemverpackungen sowie Applikatoren zur Verfügung zu stellen, deren Barriereeigenschaften insbesondere gegenüber Parfümölen eine Verwendung für kosmetische oder dermatologische Zubereitungen ermöglichen.

Diese Aufgabe wird durch die Verwendung von oberflächenbehandelten Behältnissen, Funktions- und Systemverpackungen sowie Applikatoren zur Bereitstellung und Applikation von kosmetischen und/oder dermatologischen Zubereitungen erreichet, wobei durch die Oberflächenbehandlung eine funktionale Schicht zumindest auf den zubereitungsberührenden Oberflächen erzeugt.

Eine Oberflächenbehandlung im Sinne der erfindungsgemäßen Verwendung, ist die Beschichtung der entsprechenden Oberfläche mit unlöslichen inerten anorganischen Substanzen, wie zum Beispiel Siliziumoxid und/oder unlöslichen Metalloxiden. Eine solche Beschichtung wird im Rahmen der Erfindung als Glas bezeichnet.

Glas, also eine Schicht aus Siliziumoxid und/oder unlöslichen Metalloxiden, ist ein inertes, hydrophobes, optisch transparentes, biokompatibles, polymeres Beschichtungsmaterial mit einem weiten industriellen Anwendungsspektrum.

Die Beschichtung des Substrates erfolgt durch Plasmapolymerisation.

Bei der Plasmapolymerisation werden dampfförmige organische Vorläuferverbindungen (Precursor-Monomere) in der Prozesskammer durch ein Plasma zunächst aktiviert. Durch die Aktivierung entstehen ionisierte Moleküle und es bilden sich bereits in der Gasphase erste Molekülfragmenten in Form von Clustern oder Ketten. Die anschließende Kondensation dieser Fragmente auf der Substratoberfläche bewirkt dann unter Einwirkung von Substrattemperatur, Elektronen- und Ionenbeschuss die Polymerisation und somit die Bildung einer geschlossenen Schicht.

Dabei ist praktisch jedes Substratmaterial wie z. B. Kunststoffe, insbesondere PET, PP, PE, PLA, SAN und ABS, sowie Glas, Keramik und Silikone mit Glas beschichtbar. Durch die gasförmige Abscheidung aus dem Plasma werden auch Strukturen erreicht und beschichtet, die durch Abscheidung aus Flüssigkeiten nicht beschichtbar sind, wie z. B. scharfe Ränder und Spitzen oder Hinterschneidungen.

Als Precursor werden gasförmige oder im Vakuum flüchtige Substanzen eingesetzt, die durch Mikrowellenentladung, plasmaaktivierte Variante der chemischen Gasphasenabscheidung (PE-CVD), das Glas bilden. Zum Aufbau von erfindungsgemäßen Gläsern aus Siliziumoxid eignen sich besonders gut Hexamethyldisiloxan (HMDSO) und/oder Hexamethyldisilazan (HMDSN) in einer mit Sauerstoff dotierten Atmosphäre, woraus sich eine SiOₓ-Schicht abscheidet und als Nebenprodukte CO₂ und H₂O beziehungsweise NO_{y} entstehen.

Die Reaktion sieht wie folgt aus (nicht stöchimetrische Darstellung):

Si(CH₃)₃-O-Si(CH₃)₃ + O₂ -> SiOₓ + CO₂ + H₂O

Si(CH₃)₃-N-Si(CH₃)₃ + O₂ -> SiOₓ + CO₂ + NOy + H₂O

Faktisch werden HMDSO und/oder HMDSN, zwei flüssige Siloxan-Öle, die oder einzeln mit einem Gemisch aus O₂ und oder Argon in einen hochevakuierten Hohlkörper (bspw. eine Flasche) über eine Gaslanze eingesprüht im Vakuum mittels einer Mikrowellenentladung zersetzt. Die Mikrowellenentladung lässt ein Plasma entstehen, welches zu dieser Zersetzungsreaktion führt. Die Bindung der SiOₓ Schicht erfolgt nicht allein durch physikalischen Schichtaufbau, sondern auch durch echte, kovalente Bindungen welche die aktivierte Polymeroberfläche mit dem SiOₓ eingeht.

Glas besitzt gute Barriereeigenschaften und Oberflächeneigenschaften. Aufgrund dessen werden Glasbeschichtungen hauptsächlich in zwei Bereichen eingesetzt, zur Beschichtung von Gläsern (Brillengläser oder auch Windschutzscheiben & Fassadenscheiben), um spezielle, wasserabweisende Effekte zu erreichen und Glasscheiben gegenüber dem Aussalzen und der Hydrolyse unanfälliger zu machen und zur Innenbeschichtung von Kunststoffgetränkeflaschen (meist PET), um hier für eine erhöhte Gas- und Aromabarriere zu sorgen.

Erfindungsgemäße Glasbeschichtungen sind eine hydrophobe, chemisch resistente Beschichtung mit sehr guter Barrierenwirkung gegenüber anorganischen und organischen Medien (z. B. Ölen), starken Säuren, Laugen, Gasen und Wasserdampf. Als dünne und transparente Beschichtung ist sie geeignet für komplex gestaltete Substrate auch auf Kanten. Als biostabile und biokompatible Beschichtung sind sie zulassungsfähig, zum Beispiel bei der FDA.

Die dadurch aufgebauten weit unter 1 Mikrometer starken funktionellen Dünnschichten beeinträchtigen die normalen Materialeigenschaften wir Festigkeit, Farbe, Elastizität nicht, führen jedoch zu deutlich verbesserten Diffusionsbarriereeigenschaften und Quellverhalten.

Besonders vorteilhaft sind Schichten mit einer Dicke von 10 bis 250 nm, da bei höheren Schichtdicken die Brüchigkeit stark zunimmt. Besonders vorteilhaft sind Schichtdicken von 30 bis 50 nm, da hier die Barrierewirkung in Bezug auf die mechanische Stabilität optimal ist.

Die Modifikation von Kunststoffoberflächen durch Siliziumoxid- oder Metalloxid-Beschichtung ist an sich aus der Lebensmittelindustrie bekannt (WO 1995/21948). Ziel dieser herkömmlichen Modifizierungen ist es, die Desorption von Verpackungsmaterialkomponenten in die Lebensmittel und die Absorption von Lebensmittelbestandteilen in die Verpackungswände zu verhindern bzw. zu verringern. Eine solche Behandlung wird daher auch nur an den mit Lebensmitteln in Kontakt kommenden Oberflächen ausgeführt.

Die zu beschichtenden Oberflächen werden im Beschichtungsprozess automatisch durch die Plasmabehandlung gereinigt, so dass keine spezielle Vorbehandlung nötig ist.

Im Sinne der erfindungsgemäßen Verwendung ist es daher sinnvoll, oberflächenbehandelte Behältnissen, Funktions- und Systemverpackungen sowie Applikatoren aus Polyethylen (PE, insbesondere HDPE), Polypropylen (PP) und Polyethylentherephthalat (PET) sowie Styrol-Polymere wie PS, SAN oder ABS in Verbindung mit kosmetischen und/oder dermatologischen Zubereitungen zu verwenden.

Erfindungsgemäß bevorzugt werden Hohlkörper mit einer gewissen Steifigkeit, wie zum Beispiel Tuben-Flaschen (sogenannte Tottles), Flaschen sowie Tiegel beschichtet.

Besonders vorteilhaft ist es, die beschichteten Materialien in Verbindung mit kosmetischen oder dermatologischen Zubereitungen die mindestens eine Substanz aus der Gruppe A enthalten zu verwenden, da diese besonders häufig zur Quellung führen.

Die Gruppe (A) umfasst: 1,3,4,6,7,8-Hexahydro-4,6,6,7,8,8-hexamethylcyclopenta-gamma-2-benzopyran, 2,6-Dimethyl-7-octen-2-ol, 2-Acetonapthone-1,2,3,4,5,6,7,8-octahydro-2,3,8,8-tetramethyl, 2-Isobutyl-4-hydroxy-4-methyltetrahydropyran, 2-tert-Pentylcyclohexylacetat, 3,7-Dimethyl-2,6-octadien-1-ol, 3-Methyl-5-phenyl-1-pentanol, 7-Acetyl-1,1,3,4,4,6-hexamethyltetralin, Adipinsäurediester, alpha-Amylcinnamaldehyd, alpha-Isomethylionon, Al-pha-Methylionon, Amyl C Butylphenylmethylpropionalcinnamal, Amylcinnamylalkohol, Amylsali-cylat, Anisalkohol, Benzoin, Benzylacetat, Benzylalkohol, Benzylbenzoat, Benzylcinnamat, Benzylsalicylat, Bergamotöl, bitteres Orangenöl, Butylphenylmethylpropioal, Cardamomöl, Cedrol, Cinnamal, Cinnamylalkohol, Citral, Citronellol, Citronellylmethylcrotonat, Citronenöl, Coumarin, Diethylsuccinat, d-Limonene, Ethylenbrassylate, Ethyllinalool, Eugenol, Evernia Furfuracea Extract, Evernia Prunastri Extract, Farnesol, Geraniol, Guajakholzöl, Heliotropin, Hexylcinnamal, Hexylsalicylat, Hydroxycitronellal, Hydroxyisohexyl 3-Cyclohexencarboxaldehyde, Isoeugenol, Lavendelöl, Lemonenöl, Limonen, Linalool, Linalylacetat, Mandarinenöl, Menthyl PCA, Methyl-2 Octynoat, Methylbenzoat, BHT, Methylcedrylketone, Methyldihydrojasmonate, Methylheptenon, Muskatnussöl, p-t-Butyl-alpha-methyldihydrocinnamic aldehyde, Rosmarinöl, süßes Orangenöl, Terpineol, Tonkabohnenöl, Triethylcitrat, Vanillin.

Die Erfindung betrifft auch ein Kombinationsprodukt umfassend ein Packmittel enthaltend eine kosmetische und/oder dermatologische Zubereitung umfassend ein oder mehrere Lipide, dadurch gekennzeichnet, dass das Packmittel an den Berührungsflächen mit der Zubereitung mit Glas beschichtet ist.

Die erfindungsgemäßen kosmetischen oder dermatologischen Zubereitungen umfassen ein oder mehrere Lipide. Lipid ist ein Sammelbegriff für alle Fettstoffe, wie Öle und Wachse und lipophile Emulgatoren, UV Filter, Spreiter und umfassen auch Fettstoffe natürlichen Ursprungs, die beispielsweise aus Erdöl hergestellt sind. Fettstoffe schützen die Haut vor dem Austrocknen und schädlichen Umwelteinflüssen. Sie spenden Feuchtigkeit und glätten die Hautstruktur. Lipide haben einen positiven Effekt auf die Pflegeeigenschaften des kosmetischen oder dermatologischen Produkts. Sie verbessern die Verteilbarkeit, Reichhaltigkeit und erzeugen ein glattes und geschmeidiges Hautgefühl. Das Aussehen wird durch den Anteil an Lipiden ebenfalls positiv beeinflusst: Je höher der Anteil, desto weißer, reichhaltiger und glänzender sieht beispielsweise eine Emulsion aus.

Aufgrund dieser Vorteile ist ein einfacher Verzicht auf Lipidkomponenten in der kosmetischen Zubereitung um die Problematik der Packmittelmigration zu verhindern nicht möglich.

Die erfindungsgemäßen Zubereitungen können kosmetische Hilfsstoffe enthalten, wie sie üblicherweise in solchen Zubereitungen verwendet werden, z.B. Konservierungsmittel, Bakterizide, UV-Filter, Antioxidantien, wasserlösliche Vitamine, Mineralstoffe, suspendierte Festkörperpartikel, Substanzen zum Verhindern des Schäumens, Farbstoffe, Pigmente, die eine färbende Wirkung haben, Verdickungsmittel, anfeuchtende und/oder feuchthaltende Substanzen oder andere übliche Bestandteile einer kosmetischen oder dermatologischen Formulierung wie Alkohole, Polyole, Polymere, Schaumstabilisatoren oder Silikonderivate.

Neben anderen in der Kosmetik üblichen Hilfs- und Zusatzstoffen, können die erfindungsgemäßen Zubereitungen selbstverständlich auch Pflanzenextrakte, insbesondere auch solche auf einer lipophilen Trägermatrix beinhalten. Derartige Extrakte können z.B. durch Pressen von Fruchtfleisch oder Samen, oder durch die Verwendung zusätzlicher Extraktions- bzw. Trägermittel an Teilen der entsprechenden Pflanze oder deren Frucht bereit gestellt werden.

Bevorzugt sind die Packmittel aus Polyolefinen aufgebaut oder zumindest beinhalten sie Polyolefine (PE, PP). Aber auch andere Packmaterialien wie Kunststoffe (inkl. deren Blends) wie Styrol-Polymere (PS, SAN, ABS, etc.), PET, PMMA, PC, die Familie der PHA's, PHB's, PLA, Cellulose,-Derivate - aber auch Glas kann Bestandteil erfindungsgemäßer Packmittel sein. Auch Roll-on Verpackungen deren Kugel und/oder Fitment aus PE bzw. PP aufgebaut sind, sind als erfindungsgemäße polyolefinische Packmittel zu verstehen.

Ebenso sind unter polyolefischen Packmitteln alldiejenigen Packmittel zu verstehen, die vollständig aus Polyolefinen bestehen oder nur Teile aus Polyolefinen, insbesondere Polypropylen, umfassen, die in Kontakt mit der Zubereitungen stehen können.

Da ein Packmittel beispielsweise auch ein bag-in-can System darstellen kann, indem eine Zubereitung in einem im Packmittel enthaltenen zusätzlichen Beutel aufbewahrt wird, ist erfindungsgemäß sowohl der innere Beutel als auch das äußere Packmittel als Packmittel zu verstehen.

Ebenso erfindungsgemäß ist eine Beschichtung des Packmittels mit Glas nur an den Stellen notwendig an denen das Packmittel in Berührung mit der sie enthaltenen Zubereitungen kommen kann. Am Beispiel bag-in can wäre dabei das umgebende Packmittel beispielsweise nur an der Ausgabeöffnung, an der die Zubereitung auf den Beutel trifft, mit Glas zu beschichten. Dies ermöglicht einen resourcesparenden Einsatz der erfindungsgemäßen Glasbeschichtung.

Als Packmittel werden erfindungsgemäß insbesondere Tuben, Flaschen wie Roll-ons und andere stabile Kleinhohlkörper, Tiegel, Sticks, Airless-Spender, Lotion- und Zerstäuberpumpen und Pumpenbauteile, Deckel, Applikatoren, Aerosol-Header (Sprühköpfe), Steigrohre, Sachets und dafür geeignete Folien bzw. Verbundmaterialien angesehen.

Vergleichsversuche zu unbehandelten Polymerproben haben gezeigt, dass die Quellung in allen Fällen auf weniger als ein Zehntel gesenkt werden kann (Tabelle 1).

In einem Vergleichsversuch wurde das Quellverhalten HDPE Flaschen untersucht.

Es wurden verschiedene Flaschen (150 ml, 250 ml und 400 ml) sowie Tiegel (50 ml) bestehend aus PE, PP, PET und SAN einer SiOx-Beschichtung unterzogen. Als Precursor für den PE-CVD Prozess wurde ein Gemisch aus Hexamethyldisiloxan (HMDSO) und Hexamethyldisilazan (HMDSN) verwendet.

Der BIF (Barrier Improvement Factor) der beschichteten Flaschen gegenüber den unbeschichteten Flaschen lag im Mittel bei 86,9. Der BIF ist der Quotient aus Durchlässigkeit von Sauerstoff ohne Beschichtung und Durchlässigkeit von Sauerstoff mit Beschichtung.

Der BIF beschreibt die Verbesserung der Barrierewirkung gegenüber Sauerstoffdiffusion. Ein BIF bedeutet keine Barrierestärkung, ein BIF über 1 bedeuten eine Steigerung der Barrierewirkung.

Die Sauerstoffdurchlässigkeit (OTR - Oxigen Transmission Rate) wurde bei einem Druck von 0,21 bar gemessen und auf Oberfläche und Diffusionszeit normalisiert.

In die Behältnisse wurden Rezepturen, welche z.T. die beschriebenen Inhaltsstoffe enthielten sowie einzelnen Inhaltsstoffe abgefüllt und jeweils bei Raumtemperatur sowie 40° insgesamt 6 Monate lang gelagert.

Bei einer anschl. Begutachtung wurde die geometrische sowie haptische und organoleptische Veränderung des Behälters einerseits und Veränderungen des Füllgutes andererseits untersucht. Es konnte gezeigt werden, dass unbehandelte (unbeschichtete) Behältnisse bereits starke negative Veränderungen erfahren haben. Sichtbar waren zum Beispiel starke Flaschendeformation, Etikettenablöseeffekte und durchmigrierte Rohstoffe in Form einer Schmierschicht an der Außenwand des Behälters. Die mit SiOₓ beschichteten Behältnisse zeigten diese Defekte nicht.

Es zeigte sich somit, dass mit der Glasschicht eine sehr gute Barriere gegen das darin abgefüllte Lipid enthaltene Füllgut erreicht wird.

Dies war für den Fachmann überraschend, da bisherige Versuche mit anderen Beschichtungsverfahren, beispielsweise mit Acetylen, gezeigt haben, das keine oder kaum eine Wirkung hatten.

**Tabelle 1**

| Behältnis | Inhalt | Lagerart | Massenzunahme unbeschichtete Flasche (nach 6 Monaten) | Massenzunahme mit SiOₓ "RUN 1" beschichtete Flasche (nach 6 Monaten) |
|---|---|---|---|---|
| 400ml HDPE Flasche (Flaschengewicht 31g) | NIVEA Body Milk | RT | 0,65g | 0,09g |
| 400ml HDPE Flasche (Flaschengewicht 31g) | NIVEA Body Milk | RT + Licht | 1,31g | 0,25g |
| 400ml HDPE Flasche (Flaschengewicht 31g) | NIVEA Body Milk | 40°C | 1,60g | 0,54 |
| 400ml HDPE Flasche (Flaschengewicht 31g) | C12-15 Alkyl Benzoate | RT | 1,39g | 0,05g |
| 400ml HDPE Flasche (Flaschengewicht 31g) | C12-15 Alkyl Benzoate | RT + Licht | 1,57g | 0,06g |
| 400ml HDPE Flasche (Flaschengewicht 31g) | C12-15 Alkyl Benzoate | 40°C | 1,72g | 0,28g |

| | | | | |
|---|---|---|---|---|
| RT = Raumtemperatur (ca. 20 °C) / Licht = Lagerung am Fenster, natürliche Sonneneinstrahlung / 40°C = Lagerung im Wärmeschrank bei 40°C ohne Lichteinfluss | | | | |

## Patentansprüche

1. Verwendung von oberflächenbehandelten Behältnissen, Funktions- und Systemverpackungen sowie Applikatoren zur Umhüllung und/oder Bereitstellung und/oder Applikation von kosmetischen und/oder dermatologischen Zubereitungen, **dadurch gekennzeichnet, dass** durch die Oberflächenbehandlung eine funktionale Schicht aus Siliziumoxid und/oder unlöslichen Metalloxid (Glas) zumindest auf den zubereitungsberührenden Oberflächen erzeugt wurde, **dadurch gekennzeichnet, dass** die kosmetischen und/oder dermatologischen Zubereitung mindestens ein Parfümöl enthält.

2. Verwendung einer funktionalen Schicht aus Siliziumoxid und/oder unlöslichen Metalloxid (Glas) zur Verhinderung der Veränderung des olfaktorischen Eindrucks einer in einem Behältnis befindlichen kosmetischen und/oder dermatologischen Zubereitung, **dadurch gekennzeichnet, dass** die funktionale Schicht auf der Innenwand des Behältnisses aufgebracht ist und die kosmetischen und/oder dermatologischen Zubereitung mindestens ein Parfümöl enthält.

3. Verwendung nach Anspruch 1 oder 2, **dadurch gekennzeichnet, dass** die bereitgestellte oder applizierte kosmetische und/oder dermatologische Zubereitung mindestens ein Parfümöl der Gruppe A enthält, wobei die Gruppe A umfasst:

4. Verwendung nach Anspruch mindestens einem der vorhergehenden Ansprüche, **dadurch gekennzeichnet, dass** die die bereitgestellte oder applizierte kosmetische und/oder dermatologische Zubereitung mindestens eine Substanz aus der Gruppe B enthält, wobei die Gruppe B umfasst:
1,3,4,6,7,8-Hexahydro-4,6,6,7,8,8-hexamethylcyclopenta-gamma-2-benzopyran, 2,6-Dimethyl-7-octen-2-ol, 2-Acetonapthone-1,2,3,4,5,6,7,8-octahydro-2,3,8,8-tetramethyl, 2-Isobutyl-4-hydroxy-4-methyltetrahydropyran, 2-tert-Pentylcyclohexylacetat, 3,7-Dimethyl-2,6-octadien-1-ol, 3-Methyl-5-phenyl-1-pentanol, 7-Acetyl-1,1,3,4,4,6-hexamethyltetralin, Adipinsäurediester, alpha-Amylcinnamaldehyd, alpha-Isomethylionon, Alpha-Methylionon, Amyl C Butylphenylmethylpropionalcinnamal, Amylcinnamylalkohol, Amylsalicylat, Anisalkohol, Benzoin, Benzylacetat, Benzylalkohol, Benzylbenzoat, Benzylcinnamat, Benzylsalicylat, Bergamotöl, bitteres Orangenöl, Butylphenylmethylpropioal, Cardamomöl, Cedrol, Cinnamal, Cinnamylalkohol, Citral, Citronellol, Citronellylmethylcrotonat, Citronenöl, Coumarin, Diethylsuccinat, d-Limonene, Ethylenbrassylate, Ethyllinalool, Eugenol, Evernia Furfuracea Extract, Evernia Prunastri Extract, Farnesol, Geraniol, Guajakholzöl, Heliotropin, Hexylcinnamal, Hexylsalicylat, Hydroxycitronellal, Hydroxyisohexyl 3-Cyclohexencarboxaldehyde, Isoeugenol, Lavendelöl, Lemonenöl, Limonen, Linalool, Linalylacetat, Mandarinenöl, Menthyl PCA, Methyl-2 Octynoat, Methylbenzoat, BHT, Methylcedrylketone, Methyldihydrojasmonate, Methylheptenon, Muskatnussöl, p-t-Butyl-alpha-methyldihydrocinnamic aldehyde, Rosmarinöl, süßes Orangenöl, Terpineol, Tonkabohnenöl, Triethylcitrat, Vanillin.

5. Verwendung nach mindestens einem der vorhergehenden Ansprüche, **dadurch gekennzeichnet, dass** die funktionale Schicht (Glasschicht) eine Dicke von 10 bis 250 Nanometer, insbesondere 30 bis 50 nm, aufweist.
